Europäisches Patentamt

European Patent Office

Office européen des brevets

(19)

(11) Veröffentlichungsnummer: **0 328 938 B1**

## (12) EUROPÄISCHE PATENTSCHRIFT

(45) Veröffentlichungstag der Patentschrift: **25.08.93**

(51) Int. Cl.⁵: **G01R 15/04**

(21) Anmeldenummer: **89101707.1**

(22) Anmeldetag: **01.02.89**

(54) **Isolierteil zum Einsatz in Hochspannungsanlagen.**

(30) Priorität: **12.02.88 DE 3804381**

(43) Veröffentlichungstag der Anmeldung:
**23.08.89 Patentblatt 89/34**

(45) Bekanntmachung des Hinweises auf die
Patenterteilung:
**25.08.93 Patentblatt 93/34**

(84) Benannte Vertragsstaaten:
**DE FR GB NL**

(56) Entgegenhaltungen:
EP-A- 0 131 067    EP-A- 0 131 544
CH-A- 105 521    FR-A- 2 040 672
FR-A- 2 506 025    GB-A- 1 510 264

JAPANESE JOURNAL OF APPLIED PHYSICS,
Band 15, Nr. 10, 1976, Seiten 2037-2038; Y.
KUBOTA et al.: "A quick response high voltage divider"

IDEM

(73) Patentinhaber: **AEG Sachsenwerk GmbH
Rathenaustr. 2
D-93055 Regensburg(DE)**

(72) Erfinder: **Stegmüller, Karl, Dipl.-Ing.(FH)
Galgenberg-West 11
D-8401 Wiesent(DE)**

(74) Vertreter: **Breiter, Achim, Dipl.-Ing.
AEG Aktiengesellschaft, Patent- und Lizenzwesen, Theodor-Stern-Kai 1
D-60591 Frankfurt (DE)**

## Beschreibung

Die Erfindung betrifft ein Isolierteil gemäß dem Oberbegriff des Anspruchs 1.

Bei einem bekannten Isolierteil dieser Art (GB-A-1 510 264) ist ein Isolierteil aus Kunststoff vorgesehen, der aus einem Gemisch aus Polyurethan und Siliconcarbid-Füllstoff hergestellt ist. In diesen Isolierkörper ist endseitig je eine Metallarmatur eingeformt, die gleichzeitig auch die Stirnflächen des Isolierkörpers überdecken. Die eine Metallarmatur ist dabei mit hochspannungsführenden aktiven Teilen verbunden, während die andere Metallarmatur an geerdete Teile anzuschließen ist. Die in den Kunststoff eingebetteten Silikoncarbidpartikel erzeugen eine elektrische Leitfähigkeit, die zu einer Erwärmung des Isolierteils führen. Dadurch wird vermieden, daß sich daran Feuchtigkeit niederschlägt.

Es ist auch ein Hochspannungs-Spannungsteiler bekannt (Japanese Journal of Applied Physics, Band 15, Nr. 10, 1976, Seiten 2037 bis 2038). Dieser Spannungsteiler besteht aus zwei konzentrisch angeordneten Plexiglasrohren, die endseitig durch Elektroden verschlossen sind. Innerhalb der Hohlräume befindet sich eine Lösung aus $CuSO_4$ als elektrisches Widerstandsmaterial. In eine der endseitigen Elektroden ist mittig eine weitere Elektrode eingesetzt, die in den inneren Hohlraum dieser Anordnung ragt und einen Spannungsteilerabgriff bildet, dessen elektrischer Anschluß nach außen als Steckfahne über die äußere Ebene der betreffenden Elektrode herausgeführt ist. Dieser Spannungsteilerwiderstand dient zur Messung von steilen Hochspannungsimpulsen. Die als Spannungsteilerabgriff dienende dritte Elektrode ist dabei an den Eingangsverstärker eines Oszilloskops anzuschließen.

Der Erfindung liegt die Aufgabe zugrunde, die Isolierteile von Hochspannungsanlagen so auszulegen, daß mit ihnen Spannungsteiler zur betriebsmäßigen Spannungsanzeige oder Spannungsmessung ohne Zwischenschaltung zusätzlicher Verstärker aufgebaut werden können. Bereits vorhandene Isolierteile sollen dabei ihre Abmessungen in allen wesentlichen Einzelheiten und somit ihre mechanischen und für das Isoliervermögen relevanten Eigenschaften beibehalten.

Die Lösung dieser Aufgabe erfolgt gemäß der Erfindung durch die kennzeichnenden Merkmale des Anspruchs 1.

Bei einer Ausgestaltung eines Isolierteils gemäß der Erfindung wird ein ohmscher Spannungsteiler geschaffen, bei dem der Anteil der leitfähigen Füllmittel so groß gemacht werden kann, daß durch diesen Spannungsteiler ein ausreichend großer Strom fließt, um ohne die Zwischenschaltung von zusätzlichen elektronischen Steuerkreisen oder Verstärkern die Meß- bzw. Anzeigegeräte betreiben zu können. Die Höhe des durch diesen Spannungsteiler fließenden Stromes ist dabei lediglich durch die zulässige Verlustwärme im Isolierteil begrenzt. Hierbei dient die in den Sockel zurückgesetzte Metallarmatur als Spannungsteilerabgriff, wobei ein Spannungsteilerwiderstand zwischen der hochspannungsseitigen Metallarmatur und der zurückgesetzten Metallarmatur und der zweite Spannungsteilerwiderstand zwischen der zurückgesetzten Metallarmatur und der erdseitigen Standfläche des Isolierkörpers gebildet ist. Die zurückgesetzte Metallarmatur dient dabei gleichzeitig zum Festschrauben des Isolierteils an geerdeten Teilen, wobei sie gegenüber diesen geerdeten Teilen elektrisch isoliert ist und für den Anschluß von üblichen verstärkerlosen Meß- bzw. Anzeigegeräten zu verwenden ist.

Ein wesentlicher Vorteil der Erfindung besteht darin, daß alle Isolierteile, wie Stützisolatoren, Durchführungen oder Kabelsteckverbindungen ihre durch die mechanischen und elektrischen Anforderungen gegebenen Bauformen beibehalten können und daß in ihrem Inneren die eingeformten Metallteile ebenfalls unverändert bleiben. Dadurch bleiben auch alle in Entwicklungs- und Typenprüfungen ermittelten Eigenschaften der Isolierteile gegenüber der Ausführung ohne leitfähige Zusätze zum Kunststoff erhalten. Das betrifft vor allem das mechanische Umbruchverhalten, aber auch die elektrische Durchschlags- und Kriechstromfestigkeit. Daraus folgt wiederum, daß auf der NS-Seite des Spannungsteilers keine Überspannungsschutzeinrichtungen vorzusehen sind, da keine inneren Durchschläge vorkommen können. Die unveränderte Geometrie der Isolierteile gestattet darüber hinaus zur Herstellung der erfindungsgemäßen Isolierteile die Verwendung der für die nicht durch leitfähige Zusätze veränderten Teile vorgesehenen Formeinrichtungen.

Der das erfindungsgemäße Isolierteil enthaltende Spannungsteiler arbeitet außerdem frequenzunabhängig und kann auch in Gleichstromnetzen ohne Einschränkungen eingesetzt werden.

Besonders geeignet als leitfähige Füllstoffe sind übliche anorganische Stoffe, wie Quarzmehl und Aluminiumoxyd, die in einem neuartigen Verfahren mit einer elektrisch leitfähigen Schicht überzogen werden. (EP-A- 0 131 544). Mit dem Verfahren läßt sich auf der Füllstoffoberfläche eine aus Kohlenstoff und Metall bestehende leitfähige Schicht herstellen. Als Metalle kommen dabei Ni und Cu in Frage. Die damit hergestellten gießfähigen Kunststoffe haben einen minimalen spezifischen Durchgangswiderstand in der Größenordnung von $10^3$ $\Omega cm$, während die nicht leitfähig gemachten Harze einen solchen von $10^{15}$ $\Omega cm$ und mehr aufweisen.

Auch reiner Kohlenstoff eignet sich in Form von Ruß als Zusatz zur Produktion von leitfähigen Kunststoffen.

Leitfähiges formbares Material aus synthetischem Harz wird nach EP-A- 0 131 067 auch als Muttertabletten gebildet, die aus einem Bündel von Metallfasern bestehen, das innerhalb einer Schicht aus synthetischem Harz in Längsrichtung derselben liegend in diese eingebracht ist. Mit diesem Werkstoff lassen sich Formteile produzieren, die durch die Metallfasern eine gewisse elektrische Leitfähigkeit erhalten.

Die erfindungsgemäßen Isolierteile können auch aus einem Kunststoff hergestellt werden, der zu einem Teil mit einem leitfähigen und zum anderen Teil mit nicht leitfähigen Füllmitteln gemischt ist. Auf diese Weise lassen sich die elektrischen und die mechanischen Eigenschaften unabhängig voneinander beeinflussen.

Weitere vorteilhafte Ausführungsdetails sind den Unteransprüchen zu entnehmen.

Im folgenden wird die Erfindung an Hand von Zeichnungen näher erläutert.

Figur 1    Schematische Darstellung eines erfindungsgemäßen Isolierteils mit Spannungsmeßkreis.

Figur 2    Stützisolator.

Figur 3    Schematische Darstellung eines zu Figur 1 abgewandelten Meßkreises.

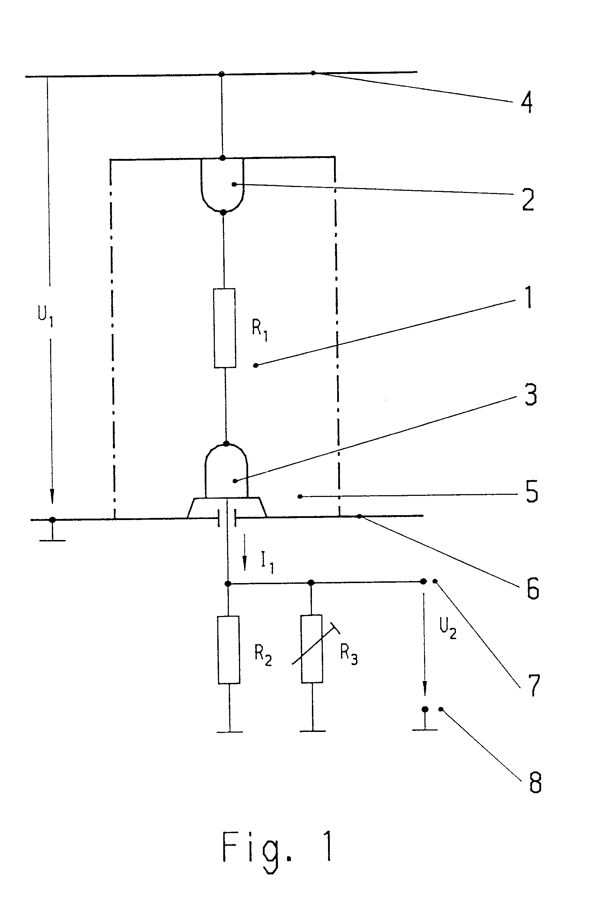

Auf Figur 1 ist ein Isolierkörper 1 in schematischer Darstellung angegeben, für das zwischen der hochspannungsseitigen (2) und der erdpotentialnahen Armatur (3) durch leitfähige Zusätze zum Kunststoff ein Widerstand $R_1$ eingestellt ist. Die Armatur 2 ist mit einer an der Spannung $U_1$ liegende Sammelschiene 4 verbunden, während der Sockel 5 auf der geerdeten Grundfläche 6 ruht. An der Armatur 3 ist der Isolierkörper 1 festgeschraubt, wobei diese Verbindung gegen die geerdete Grundfläche 6 isoliert sein muß. An die Armatur 3 ist ein geerdeter Meßwiderstand $R_2$ angeschlossen, an dessen Klemmen 7, 8 die Meßspannung $U_2$ mittels eines Anzeigegerätes A oder eines Meßinstrumentes M direkt, ohne Zwischenschaltung eines Verstärkers abgegriffen werden kann. Zur Einstellung des Meßbereiches kann parallel zum Widerstand $R_2$ ein Potentiometer $R_3$ vorgesehen werden.

Da der Widerstand $R_2$ sowie der Innenwiderstand der Geräte A bzw. M gegenüber $R_1$ vernachlässigbar klein sind, wird der Ableitstrom $I_1$ allein durch den Widerstand $R_1$ bestimmt:

$$I_1 \sim \frac{U_1}{R_1} \ .$$

Die durch den Ableitstrom $I_1$ im Isolierkörper 1 erzeugte Wärme wird zu einem großen Teil über die benachbarten Metallteile, wie Sammelschiene 4 und Grundfläche 6 abgeführt, der Rest erhöht die Temperatur des Isolierkörpers 1 geringfügig.

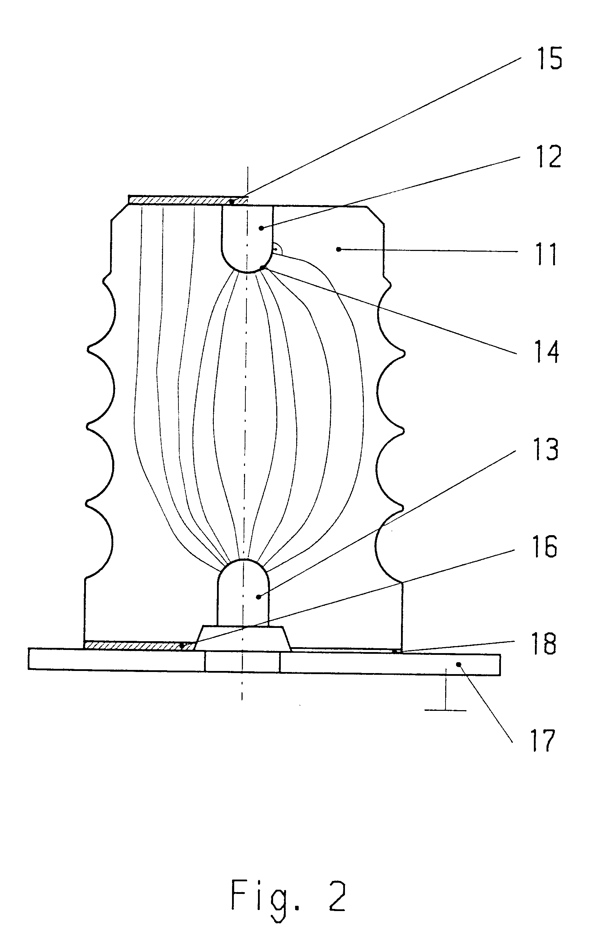

In Figur 2 ist ein einfacher rotationssymmetrischer Stützisolator 11 mit der Kopfarmatur 12 und der zurückgesetzten Fußarmatur 13 zu sehen. Das durch Anlegen der Spannung $U_1$ entstehende Strömungsfeld des Ableitstromes $I_1$ ist an der Spitze 14 der Kopfarmatur 12 sehr konzentriert (rechte Hälfte von Figur 2). Eine Vergrößerung des Stromes $I_1$ und eine gleichmäßige Verteilung im Isolatorquerschnitt kann nach einem weiteren Merkmal der Erfindung durch eine angeformte Platte 15 an der Kopfseite des Isolators 11 herbeigeführt werden. Auf der linken Hälfte der Figur 2 ist das dabei entstehende Strömungsfeld zum Vergleich gezeichnet. Auch an der Fußseite des Isolators 11 kann eine Platte 16 angeformt sein. Diese verbessert die Wärmeableitung aus dem Stützisolator 11 in das geerdete Gerüstteil 17 der Hochspannungsanlage.

Die für Stützisolatoren dargestellten Maßnahmen zur Realisierung der Erfindungsidee lassen sich sinngemäß auch bei anderen isolierten Bauteilen, wie Durchführungen usw. anwenden.

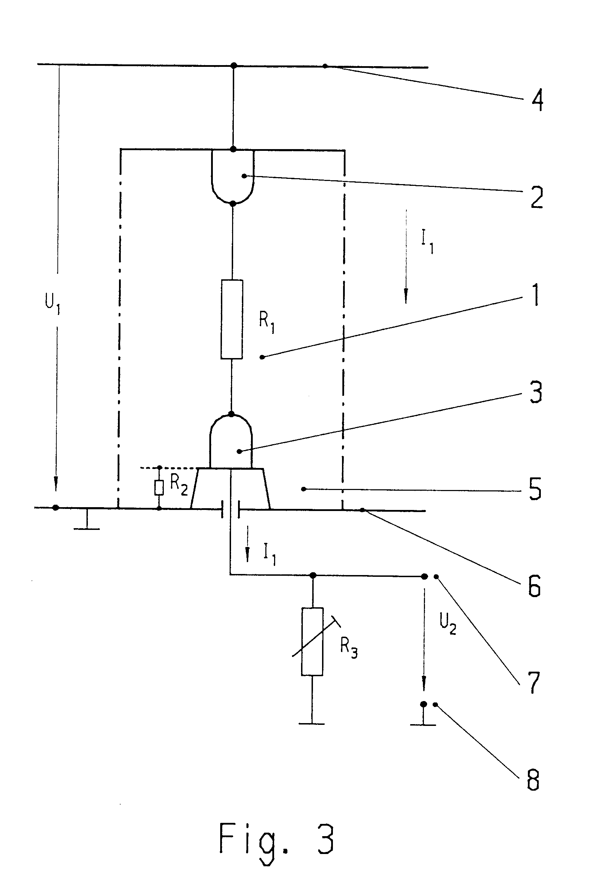

Gemäß der Erfindungsidee können nach Figur 3 im Isolator auch beide Teilerwiderstände des Spannungsteilers untergebracht werden. Während wie in Figur 1 der Teilerwiderstand $R_1$ durch den zwischen den Armaturen 2 und 3 vom Ableitstrom $I_1$ durchströmten Teil des Isolierkörpers gebildet wird, dient der zwischen der Armatur 3 und der geerdeten Grundfläche 6 sich einstellende Teil des Isolierkörpers als Teilerwiderstand $R_2$.

In Figur 3 gelten dieselben Bezugszeichen wie in Figur 1.

Bei einer Ausführung nach Figur 3 muß für einen definierten Übergang zwischen dem Sockel 5 und der geerdeten Grundfläche gesorgt werden. Dies kann, wie am Beispiel des Stützisolators nach Figur 2 dargestellt, durch die Anformung einer Platte an den Sockel 5 oder durch Aufbringung einer leitfähigen Schicht z.B. in Form einer Metallisierung 18 an die Standfläche des Stützisolators 11 erfolgen. Auch an der Kopfseite kann mit Vorteil eine solche Metallisierung 18 anstelle der Platte 15 treten.

Die eben beschriebene, vorteilhafte Ausführung der mit den beiden unterschiedlichen Potentialen der Anlage kontaktierende Endfläche kann natürlich auch für anders geformte Isolierteile, wie z.B. Durchführungen oder Kabelsteckverbindungen angewendet werden.

Bezugszeichen

Isolierkörper
1
hochspannungsseitige Armatur
2
erdpotentialnahe Armatur
3
Sammelschiene
4
Sockel
5
Grundfläche
6
Klemmen
7,8
Stützisolator
11
Kopfarmatur
12
Fußarmatur
13
Spitze
14
Platte
15
Platte
16
Gerüstteil
17
Metallisierung
18

**Patentansprüche**

1. Isolierteil zum Einsatz in Hochspannungsanlagen, mit einem Isolierkörper (1,11) aus Kunststoff und wenigstens je einer endseitig in diesen eingeformten Metallarmatur (2,12,3,13), von welchen die eine (2,12) mit hochspannungsseitig zu stützenden aktiven Teilen (4) zu verbinden ist und die andere (3,13) in der als Sockel (5) ausgebildeten Fußseite angeordnet ist, wobei die erdseitige Standfläche des Sockels (5) mit geerdeten Gerüstteilen (6,17) zu verbinden ist und wobei dem Kunststoff leitfähige Füllmittel zur Verringerung des ohmschen Widerstandes des Isolierkörpers (1,11) zugesetzt sind, dadurch gekennzeichnet, daß der Isolierkörper (1,11) als ohmscher Spannungsteiler zur Feststellung oder Messung der Hochspannung dient, wobei die im Sockel (5) angeordnete Metallarmatur (3,13) gegenüber der erdseitigen Standfläche des Sockels (5) in den Isolierkörper (1,11) zurückgesetzt ist und einen Spannungsteilerabgriff bildet sowie gegenüber den Gerüstteilen (6,17) elektrisch isoliert ist.

2. Isolierteil nach Anspruch 1, **dadurch gekennzeichnet,** daß der Isolierkörper (1,11) aus einer gießfähigen Mischung eines Isolierharzes mit einem leitfähigen Füllmittel und gegebenenfalls mit weiteren Füllstoffen besteht und daß der Anteil des leitfähigen Füllmittels die Höhe des ohmschen Widerstandes bestimmt.

3. Isolierteil nach Anspruch 1, **dadurch gekennzeichnet,** daß der Isolierkörper (1,11) aus einer spritz- oder preßfähigen Mischung eines Thermoplasten oder Duroplasten mit einem leitfähigen Füllmittel und gegebenenfalls mit weiteren Füllstoffen besteht und daß der Anteil des leitfähigen Füllmittels die Höhe des ohmschen Widerstandes bestimmt.

4. Isolierteil nach Anspruch 2 oder 3, **dadurch gekennzeichnet,** daß als leitfähiges Füllmittel mit Ni/C, oder Cu/C beschichtetes Quarzmehl vorgesehen ist.

5. Isolierteil nach Anspruch 2 oder 3, **dadurch gekennzeichnet,** daß als leitfähiges Füllmittel mit Ni/C beschichtetes Aluminiumoxyd vorgesehen ist.

6. Isolierteil nach Anspruch 2 oder 3, **dadurch gekennzeichnet,** daß als leitfähiges Füllmittel ein Leiterwerkstoff, zum Beispiel Cu oder AL, in Pulver- oder Körnerform vorgesehen ist.

7. Isolierteil nach Anspruch 2 oder 3, **dadurch gekennzeichnet,** daß dem Kunststoff gebündelte, in einer Längsrichtung innerhalb einer Schicht aus synthetischem Harz liegende Metallfasern in Tablettenform beigefügt sind.

8. Isolierteil nach Anspruch 2 oder 3, **dadurch gekennzeichnet,** daß als leitfähiges Füllmittel Ruß vorgesehen ist.

9. Isolierteil nach Anspruch 2 oder 3, **dadurch gekennzeichnet,** daß als leitfähiges Füllmittel ein Leiterwerkstoff, z.B. Cu oder AL in Form kleiner Kugeln vorgesehen ist.

10. Isolierteil nach einem der voranstehenden Ansprüche, **dadurch gekennzeichnet,** daß als Metallarmaturen (2,3,12,13) in an sich bekannter Weise mit Gewinden versehene Buchsen, Platten und dergleichen eingeformt sind.

11. Isolierteil nach einem der voranstehenden Ansprüche,
    **dadurch gekennzeichnet,**
    daß vorzugsweise bei einem Stützisolator (11) an die Kopfarmatur(en) (12) eine die Kopfseite ganz oder teilweise abdeckende metallische Platte (15) angeformt ist oder eine die Kopfarmatur(en) (12) kontaktierende leitfähige Schicht (18) z.B. durch Metallisierung aufgebracht ist.

12. Isolierteil nach einem der voranstehenden Ansprüche,
    **dadurch gekennzeichnet,**
    daß an die erdseitige Standfläche eine metallische Platte (16) angeformt ist oder eine leitfähige Schicht (18) z.ß.durch Metallisierung aufgebracht ist.

13. Isolierteil nach einem oder mehreren der voranstehenden Ansprüche,
    **dadurch gekennzeichnet,**
    daß der zwischen der hochspannungsseitigen Armatur (2) und der erdpotentialnahen Armatur (3) des Isolierteils (1) bzw. der Kopfarmatur (12) und der Fußarmatur (13) des Isolierkörpers (11) bei anliegender Spannung ($U_1$) vom Ableitstrom ($I_1$) durchflossene Teil des Isolierkörpers einen ersten Teilerwiderstand ($R_1$) bildet und daß die Anzeige oder Messung dieser Spannung durch Abgriff der am Teilerwiderstand ($R_2$) zwischen der erdpotentialnahen Armatur (3) bzw. Fußarmatur (13) und einem auf Erdpotential liegenden Anlagenbauteil, wie z.B. die Grundfläche (6) oder ein Gerüstteil (17) sich einstellenden Meßspannung ($U_2$) erfolgt.

14. Isolierteil nach Anspruch 13,
    **dadurch gekennzeichnet,**
    daß als weiterer Teilerwiderstand ($R_2$) ein getrennt angebauter,parallel zum Spannungsabgriff ($U_2$) liegender Widerstand (9) vorgesehen ist.

15. Isolierteil nach Anspruch 13 oder 14,
    **dadurch gekennzeichnet,**
    daß zur Regulierung des Meßbereichs parallel zum Abgriff der Meßspannung $U_2$ ein Potentiometer ($R_3$) vorgesehen ist.

16. Isolierteil nach einem der Ansprüche 13 bis 15,
    **dadurch gekennzeichnet,**
    daß ein Teil des Ableitstromes ($I_1$) in direktem Anschluß geeigneten Spannungsanzeige- und/oder -meßgeräten zugeführt ist.

17. Isolierteil nach einem der Ansprüche 13 bis 16,
    **dadurch gekennzeichnet,**
    daß als Anzeige - und Erfassungssystem LCD - Anzeigen zur Anwendung kommen.

**Claims**

1. Insulator for use in high-voltage installations, with an insulator element (1, 11) made of plastics material and at least one metal armature (2, 12, 3, 13) molded into each end of the insulator element, one of which metal armatures (2, 12) is to be connected with active parts (4) to be supported on the high-voltage side and the other metal armature (3, 13) is arranged in the base end constructed as a socket (5), the earth-side base of the socket (5) is to be connected with earthed framework parts (6, 17) and conductive fillers are added to the plastics material in order to reduce the ohmic resistance of the insulator element (1, 11), characterised in that the insulator element (1, 11) acts as an ohmic voltage divider for determining or measuring the high voltage, the metal armature (3, 13) arranged in the socket (5) being set back in the insulator element (1, 11) relative to the earth-side base of the socket (5), forming a voltage divider measuring point and being electrically insulated relative to the framework parts (6, 17).

2. Insulator according to claim 1, characterised in that the insulator element (1, 11) is made of a castable mixture of an insulating resin with a conductive filler and optionally with further filler materials, and the proportion of conductive filler determines the degree of the ohmic resistance.

3. Insulator according to claim 1, characterised in that the insulator element (1, 11) is made of an injectable or moldable mixture of a thermoplastics or thermosetting plastics material with a conductive filler and optionally with further filler materials, and the proportion of conductive filler determines the degree of the ohmic resistance.

4. Insulator according to claim 2 or 3, characterised in that powdered quartz coated with Ni/C or Cu/C is provided as the conductive filler.

5. Insulator according to claim 2 or 3, characterised in that aluminium oxide coated with Ni/C is provided as the conductive filler.

6. Insulator according to claim 2 or 3, characterised in that a conductor material, such as Cu or Al, is provided in powder or granular form as the conductive filler.

7. Insulator according to claim 2 or 3, characterised in that metal fibres, which are bundled and arranged longitudinally within a layer of synthetic resin, are added in tablet form to the plastics material.

8. Insulator according to claim 2 or 3, characterised in that carbon black is provided as the conductive filler.

9. Insulator according to claim 2 or 3, characterised in that a conductor material, e.g. Cu or Al, is provided in globular form as the conductive filler.

10. Insulator according to one of the preceding claims, characterised in that bushings, plates or the like provided in known manner with threads are molded as metal armatures (2, 3, 12, 13).

11. Insulator according to one of the preceding claims, characterised in that, in the case of a supporting insulator (11), a metallic plate (15) fully or partially covering the top end is preferably formed onto the top armature(s) (12) or a conductive layer (18) contacting the top armature(s) (12) is applied, e.g. by metallization.

12. Insulator according to one of the preceding claims, characterised in that a metallic plate (16) is formed onto the earth-side base or a conductive layer (18) is applied to said base, e.g. by metallization.

13. Insulator according to one of more of the preceding claims, characterised in that the part of the insulator element through which the deflecting current ($I_1$) flows between the high voltage-side armature (2) and the earth potential-side armature (3) of the insulator element (11) or between the top armature (12) and the bottom armature (13) of the insulator element (11) when the voltage ($U_1$) is applied acts as a first divider resistor ($R_1$), and the display or measurement of this voltage is effected by measuring the measurement voltage ($U_2$) flowing through the divider resistor ($R_2$) between the earth potential-side armature (3) or bottom armature (13) and an installation part connected to earth potential, such as the base (6) or a framework part (17).

14. Insulator according to claim 13, characterised in that a separately fitted resistor (9) lying parallel to the voltage measuring point ($U_2$) is provided as a further divider resistor ($R_2$).

15. Insulator according to claim 13 or 14, characterised in that a potentiometer ($R_3$) is provided parallel to the measuring point of the measurement voltage ($U_2$) for controlling the measuring range.

16. Insulator according to one of claims 13 to 15, characterised in that part of the deflecting current ($I_1$) is supplied directly to suitable voltage display- and/or measuring devices.

17. Insulator according to one of claims 13 to 16, characterised in that LCD-displays are used as a display- and recording system.

**Revendications**

1. Isolateur destiné à être utilisé dans des installations à haute tension, comportant un corps isolant (1, 11) en matière plastique et à chacune des extrémités au moins une armature métallique (2, 12, 3, 13) formée dans celui-ci, dont une (2, 12) doit être reliée à des parties actives (4) à soutenir, côté haute tension et l'autre (3, 13) est placée dans le côté pied, se présentant sous la forme d'un socle (5), la surface d'appui côté terre du socle (5) devant être reliée à des parties de structure (6, 17) mises à la terre et des matières de remplissage conductrices étant ajoutées à la matière plastique pour réduire la résistance ohmique du corps isolant (1, 11), caractérisé en ce que le corps isolant (1, 11) sert de diviseur de tension ohmique pour constater ou mesurer la haute tension, l'armature métallique (3, 13), placée dans le socle (5), étant en retrait par rapport à la surface d'appui côté terre du socle (5), dans le corps isolant (1, 11) et étant isolée électriquement par rapport aux parties de structure (6, 17).

2. Isolateur selon la revendication 1, caractérisé en ce que le corps isolant (1, 11) est réalisé dans un mélange pouvant être coulé d'une résine isolante et d'une matière de remplissage conductrice et éventuellement d'autres substances de remplissage et en ce que la fraction de la matière de remplissage conductrice détermine la valeur de la résistance ohmique.

3. Isolateur selon la revendication 1, caractérisé en ce que le corps isolant (1, 11) est réalisé dans un mélange pouvant être injecté ou pressé d'une matière thermoplastique ou thermodurcissable avec une matière de remplissage conductrice et éventuellement avec d'autres substances de remplissage et en ce que la fraction de la matière de remplissage conductrice détermine la valeur de la résistance ohmique.

4. Isolateur selon les revendications 2 ou 3, caractérisé en ce qu'il est prévu comme matière de remplissage conductrice de la poudre de quartz recouverte de Ni/C ou Cu/C.

5. Isolateur selon les revendications 2 ou 3, caractérisé en ce qu'il est prévu comme matière de remplissage conductrice de l'oxyde d'aluminium recouvert de Ni/C.

6. Isolateur selon les revendications 2 ou 3, caractérisé en ce qu'il est prévu comme matière de remplissage conductrice un matériau pour conducteur, par exemple Cu ou Al, sous forme pulvérulente ou granuleuse.

7. Isolateur selon les revendications 2 ou 3, caractérisé en ce qu'il est ajouté à la matière plastique des fibres métalliques, sous forme de pastilles, placées dans la direction longitudinale à l'intérieur d'une couche de résine synthétique.

8. Isolateur selon les revendications 2 ou 3, caractérisé en ce qu'il est prévu de la suie comme matière de remplissage conductrice.

9. Isolateur selon les revendications 2 ou 3, caractérisé en ce qu'il est prévu comme matière de remplissage conductrice un matériau pour conducteur, par exemple Cu ou Al sous forme de petites billes.

10. Isolateur selon l'une des revendications précédentes, caractérisé en ce que des douilles pourvues de filetages, des plaques et similaires sont formées, de manière connue en soi, en tant qu'armatures métalliques (2, 3, 12, 13).

11. Isolateur selon l'une des revendications précédentes, caractérisé en ce que de préférence dans le cas d'un isolateur de support (11) il est formé sur la(les) armature(s) de tête (12) une plaque (15) métallique, recouvrant totalement ou partiellement le côté de tête où il est appliqué, par exemple par métallisation, une couche (18) conductrice venant en contact avec la(les) armature(s) de tête (12).

12. Isolateur selon l'une des revendications précédentes, caractérisé en ce que sur la surface d'appui côté terre il est formé une plaque (16) métallique ou une couche (18) conductrice appliquée, par exemple par métallisation.

13. Isolateur selon une ou plusieurs des revendications précédentes, caractérisé en ce que la partie du corps isolant, traversée par le courant de dérivation ($I_1$) lorsque s'applique la tension ($U_1$), entre l'armature (2) côté haute tension et l'armature (3) proche du potentiel de terre de l'isolateur (1) ou entre l'armature de terre (12) et l'armature de pied (13) du corps isolant (11), forme une première résistance de diviseur ($R_1$) et en ce que l'affichage ou la mesure de cette tension s'effectue par prise de la tension de mesure ($U_2$) s'établissant dans la résistance de diviseur (R2), entre l'armature (3) proche du potentiel de terre ou l'armature de pied (13) et un composant de l'installation au potentiel de terre, par exemple la surface de base (6) ou une partie de structure (17).

14. Isolateur selon la revendication 13, caractérisé en ce qu'il est prévu comme autre résistance de diviseur ($R_2$) une résistance (9) montée séparément, parallèle à la prise de tension ($U_2$).

15. Isolateur selon les revendications 13 ou 14, caractérisé en ce que pour la régulation de la plage de mesure il est prévu un potentiomètre ($R_3$), parallèle à la prise de la tension de mesure ($U_2$).

16. Isolateur selon l'une des revendications 13 à 15, caractérisé en ce qu'une partie du courant de dérivation ($I_1$) est acheminée, par branchement direct, vers des appareils d'affichage et/ou de mesure de tension.

17. Isolateur selon l'une des revendications 13 à 16, caractérisé en ce qu'on utilise comme systèmes d'affichage et d'enregistrement des affichages

Fig. 1

Fig. 2

Fig. 3